# EUROPEAN PATENT APPLICATION

(11) **EP 1 420 584 A1**
(43) Date of publication of application: **19.05.2004**
(21) Application number: 02747698.5
(22) Date of filing: 19.07.2002
(51) Int. Cl.: H04N 5/92, H04N 5/76, G11B 20/10

(54) **RECORDING APPARATUS, RECORDING METHOD, PROGRAM, AND MEDIUM**

(30) Priority: 25.07.2001 JP 2001224759
(71) Applicant: MATSUSHITA ELECTRIC INDUSTRIAL CO., LTD., Kadoma-shi, Osaka 571-8501 (JP)
(72) Inventor: HAMAMOTO, Yasuo, Sakai-shi, Osaka 591-8004 (JP); MIYASHITA, Mitsuhiro, Nishinomiya-shi, Hyogo 663-8032 (JP)
(74) Representative: Schuster, Thomas, Dipl.-Phys.
(86) International application number: PCT/JP2002/007338
(87) International publication number: WO 2003/010961

(57) **Abstract**

It was impossible to easily carry recorded images and sound by using a low-capacity memory medium and to receive them in the open air.

The present invention is a recording/reproducing apparatus comprising a compression stream generation means 4 of generating (1) a first bit stream and (2) a second bit stream having a bit rate less than the bit rate of the first bit stream by using a video signal input externally, a recording/modulation means 14 of recording the generated first bit stream and the generated second bit stream on a predetermined medium, a first digital interface 21 of outputting the recorded first bit stream, and a second digital interface 22, having an interface connectable to a predetermined compact memory apparatus, of outputting the recorded second bit stream.

## Description

### TECHNICAL FIELD

The present invention relates to a recording apparatus, a recording method, a program and a medium of recording and reproducing video signals, for example, on disk-shaped recording media.

### BACKGROUND TECHNOLOGY

In recent years, recording/reproducing apparatuses that carry out recording and reproduction of digitally compressed audio/video (AV) signals by using disk-shaped recording media, such as hard disk apparatuses and optical disk apparatuses have become available.

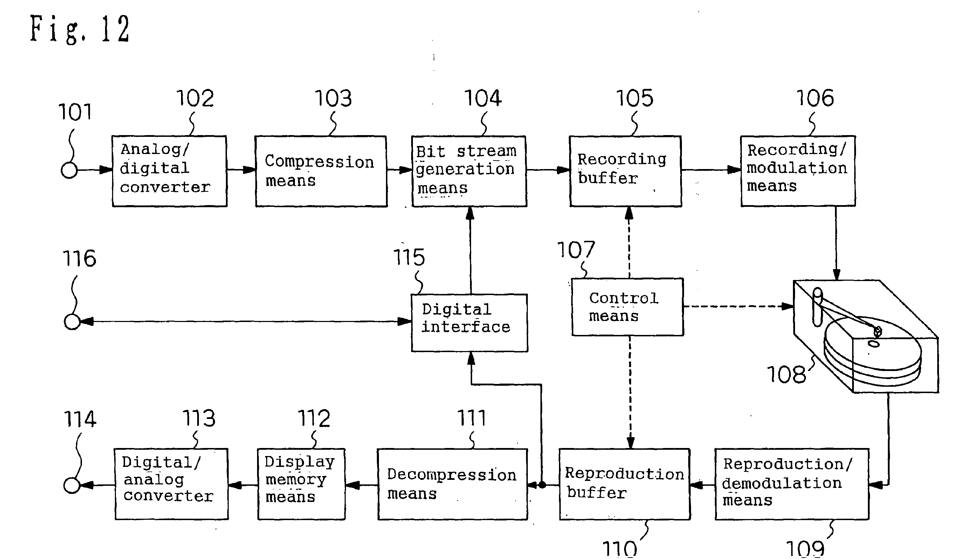

The configuration of a conventional recording/reproducing apparatus will thus be described by referring to FIG. 12 serving as the block diagram of the conventional recording/reproducing apparatus.

In FIG. 12, numeral 101 designates an analog input terminal, numeral 102 designates an analog/digital conversion means, numeral 103 designates a compression means, numeral 104 designates a bit stream generation means, numeral 105 designates a recording buffer, numeral 106 designates a recording/modulation means, numeral 107 designates a control means, numeral 108 designates a disk-shaped recording apparatus (hard disk apparatus), numeral 109 designates a reproduction/demodulation means, numeral 110 designates a reproduction buffer, numeral 111 designates a decompression means, numeral 112 designates a display memory, numeral 113 designates a digital/analog converter, numeral 114 designates an analog output terminal, numeral 115 designates a digital interface, and numeral 116 designates a digital input/output terminal.

Next, the operations of the conventional recording/reproducing apparatus will be described. Although it is explained that the input is a video signal in the following descriptions, an audio signal synchronized with the video signal is usually processed simultaneously.

The operations during recording will be described first, and the operations during reproduction will be described next.

The operations during recording are as follows:

An analog video signal input from the analog input terminal 101 is converted into a digital video signal by the analog/digital converter 102. In the case of an ordinary TV signal, a sampling frequency of 14.3 MHz or the like is used.

The digital video signal is then compressed by the compression means 103. The MPEG2 compression is widely used as a compression system; the bit rate after the compression is about several Mbps.

An error correction code or the like is then added to the compressed video signal by the bit stream generation means 104, whereby the compressed video signal becomes a recording bit stream.

The recording bit stream is then stored in the recording buffer 105, modulated optimally for recording by the recording/modulation means 106, and recorded on the disk-shaped recording apparatus 108.

The disk-shaped recording apparatus 108 usually generates a wait time for the rotation of the disk during recording; to absorb the time, the recording buffer 105 is required. Reading from the recording buffer 105 and the recording head of the disk-shaped recording apparatus 108 are controlled synchronously by the control means 107.

The operation during reproduction is as follows:

The signal reproduced from the disk-shaped recording apparatus 108, which has been modulated during recording, is demodulated by the reproduction/demodulation means 109 during reproduction.

The demodulated signal is once stored in the reproduction buffer 110, undergoes an error correction process or the like and is input to the decompression means 111.

The decompression means 111 performs the reverse processing of the image compression carried out by the compression means 103 during recording, thereby decompressing the digital video signal.

The decompressed video signal is stored in the display memory means 112 in frame units, converted into an analog video signal by the digital/analog converter 113, and output to the analog output terminal 114.

The reproduction and operations of the conventional recording/reproducing apparatus are described above.

Since the disk-shaped recording apparatus 108 is used as a recording medium, it is possible to obtain advantages, such as the above-mentioned simultaneous recording and reproduction, not obtained by conventional tape recording; hence, apparatuses that record and reproduce AV signals by using disk-shaped recording apparatuses have been disclosed or commercialized.

In addition, by inputting or outputting the digital signal obtained immediately after the above-mentioned compression means 103 or immediately before the above-mentioned decompression means 111 through the digital input/output terminal 116 via the digital interface 115, direct transmission of the digitally compressed signal to and from another AV apparatus can be carried out.

However, the above-mentioned conventional recording and reproduction of video signals are generally carried out by utilizing MPEG2 having a bit rate of several Mbps or more so that image quality having a viewable level is obtained when connection is made to a home-use large-screen TV set.

Furthermore, since the amount of recorded data in the above-mentioned conventional recording/reproducing apparatus is large, it is impossible to easily carry the recorded images and sound and to receive them in a mobile environment or the like.

### DISCLOSURE OF THE INVENTION

In consideration of this kind of problem encountered in the above-mentioned conventional apparatus, the present invention is intended to provide a recording apparatus, a recording method, a program and a medium being capable of allowing recorded images and sound to be carried easily by using a low-capacity memory medium and to be received in the open air or at a remote site via a low-speed communication line, such as a telephone line, for example.

A first invention of the present invention is a recording apparatus comprising:
generation means of generating (1) a first bit stream and (2) a second bit stream having a bit rate less than the bit rate of said first bit stream by using a video signal input externally,
recording means of recording said generated first bit stream and said generated second bit stream on a predetermined medium,
first bit stream output means of outputting said recorded first bit stream, and
second bit stream output means, having an interface connectable to a predetermined compact memory apparatus, of outputting said recorded second bit stream.

A second invention of the present invention is a recording apparatus as set forth in the first invention of the present invention, wherein the bit rate of said second bit stream is determined in consideration of the recording capacity of said compact memory means.

A third invention of the present invention is a recording apparatus as set forth in the first invention of the present invention, comprising display means of carrying out display on the basis of the contents of a control table of controlling at least said recorded second bit streams, and selection means of selecting a predetermined second bit stream from said recorded second bit streams, wherein
said second bit stream output means outputs said selected second bit stream.

A fourth invention of the present invention is a recording apparatus as set forth in the first invention of the present invention, comprising control means of controlling the received range, received by' the user, of said recorded first bit stream and said recorded second bit stream.

A fifth invention of the present invention is a recording apparatus as set forth in the fourth invention of the present invention, wherein
said recorded first bit stream is output from said first bit stream output means and used for reception by said user,
said control means controls the received range, received by said user, of said first bit.stream, and
said second bit stream output means outputs the unreceived range, other than the received range of said controlled first bit stream, of the second bit stream generated by using the video signal used to generate the first bit stream.

A sixth invention of the present invention is a recording apparatus as set forth in the fourth invention of the present invention, wherein
said recorded second bit stream is output from said second bit stream output means and used for reception by said user,
said control means controls the received range, received by said user, of said second bit stream, and
said first bit stream output means outputs the unreceived range, other than the received range of said controlled second bit stream, of the first bit stream generated by using the video signal used to generate the second bit stream.

A seventh invention of the present invention is a recording apparatus as set forth in the first invention of the present invention, comprising image display means of displaying (1) an image using a first bit stream or (2) plural images using respective plural second bit streams, having been recorded on said medium, and selection means of selecting a predetermined second bit stream from said recorded second bit streams by utilizing the result of the display of plural images by using said respective plural second bit stream, wherein
said image display means displays an image using said first bit stream by using said first bit stream generated by utilizing the video signal utilized for the generation of the selected second bit stream.

An eighth invention of the present invention is a recording apparatus as set forth in the first invention of the present invention, comprising image display means of displaying (1) an image using a first bit stream and (2) plural images using respective plural second bit streams, having been recorded on said medium, simultaneously.

A ninth invention of the present invention is a recording apparatus as set forth in the first invention of the present invention, wherein said second bit stream output means has an interface of connecting to a predetermined communication network using wire and/or wireless.

A tenth invention of the present invention is a recording method comprising:
a step of generating (1) a first bit stream and (2) a second bit stream having a bit rate less than the bit rate of said first bit stream by using a video signal input externally,
a step of recording said generated first bit stream and said generated second bit stream on a predetermined medium,
a step of outputting said recorded first bit stream, and
a step of outputting said recorded second bit stream by utilizing an interface connectable to a predetermined compact memory apparatus.

An eleventh invention of the present invention is a program causing a computer to execute all or part of: a step of generating (1) a first bit stream and (2) a second bit stream having a bit rate less than the bit rate of said first,bit stream by using a video signal input externally, a step of recording said generated first bit stream and said generated second bit stream on a predetermined medium, a step of outputting said recorded first bit stream, and a step of outputting said recorded second bit stream by utilizing an interface connectable to a predetermined compact memory apparatus; in the recording method set' forth in the tenth invention of the present invention.

A twelfth invention of the present invention is a medium having said program set forth in the eleventh invention of the present invention, being processable by a computer.

### BRIEF DESCRIPTION OF THE DRAWINGS

FIG. 1 is a block diagram of a recording/reproducing apparatus in accordance with Embodiment 1 of the present invention;
FIG. 2 is a block diagram of a recording/reproducing apparatus in accordance with Embodiment 2 of the present invention;
FIG. 3 is a block diagram of a recording/reproducing apparatus in accordance with Embodiment 3 of the present invention;
FIG. 4 is a block diagram of a recording/reproducing apparatus in accordance with Embodiment 4 of the present invention;
FIG. 5 is a block diagram of a recording/reproducing apparatus in accordance with Embodiment 6 of the present invention;
FIG. 6 is a block diagram of a recording/reproducing apparatus in accordance with Embodiment 7 of the present invention;
FIG. 7 is a conceptual view of a selection screen in accordance with Embodiment 2 of the present invention;
FIG. 8 is a conceptual view of compression setting screen 1 in accordance with Embodiment 2 of the present invention;
FIG. 9 is a conceptual view of compression setting screen 2 in accordance with Embodiment 2 of the present invention;
FIG. 10 (a) is a conceptual view of an image multi-screen (before selection) in accordance with Embodiment 4 of the present invention;
FIG. 10 (b) is a conceptual view of an image screen (after selection) in accordance with Embodiment 4 of the present invention;
FIG. 11 (a) is a conceptual view of an image multi-screen (before replacement) in accordance with Embodiment 5 of the present invention;
FIG. 11 (b) is a conceptual view of an image screen (after replacement) in accordance with Embodiment 5 of the present invention; and
FIG. 12 is the block diagram of the conventional recording/reproducing apparatus.

### (Explanation of numerals)

- 1: Analog input terminal
- 2: Analog/digital converter
- 3: Input terminal
- 4: Compression stream generation means
- 5: First compression means
- 6: First bit stream generation means
- 7: Second compression means
- 8: Second bit stream generation means
- 9, 10: Output terminal
- 11: First recording buffer
- 12: Second recording buffer
- 13, 18: Switch
- 14: Recording/modulation means
- 15: First control means
- 16: Disk-shaped recording/reproducing apparatus
- 17: Reproduction/demodulation means
- 19: First reproduction buffer
- 20: Second reproduction buffer
- 21: First digital interface
- 22: Second digital interface
- 23: First digital input/output terminal
- 24: Second digital input/output terminal
- 25: First decompression means
- 26: Display memory means
- 27: Digital/analog converter
- 28: Analog output terminal
- 29: Control table recording/reproducing means
- 30: Remote-control means
- 31: Second control means
- 32: Display-use table processing means
- 33: Cursor display means
- 34: Flash memory means
- 35: First reception time judgment means
- 36: Second reception time judgment means
- 37: Second decompression means
- 38: Connection means
- 39: Wireless transmission
- 40: First portable terminal
- 41: Second portable terminal
- 42: First Internet provider
- 43: Second Internet provider
- 44: Third Internet provider
- 45: Internet
- 46: Fourth Internet provider
- 47: Fixed terminal
- 48: Recording apparatus

### THE BEST MODE FOR CARRYING OUT THE INVENTION

Embodiments in accordance with the present invention will be described below referring to the drawings.

### (Embodiment 1)

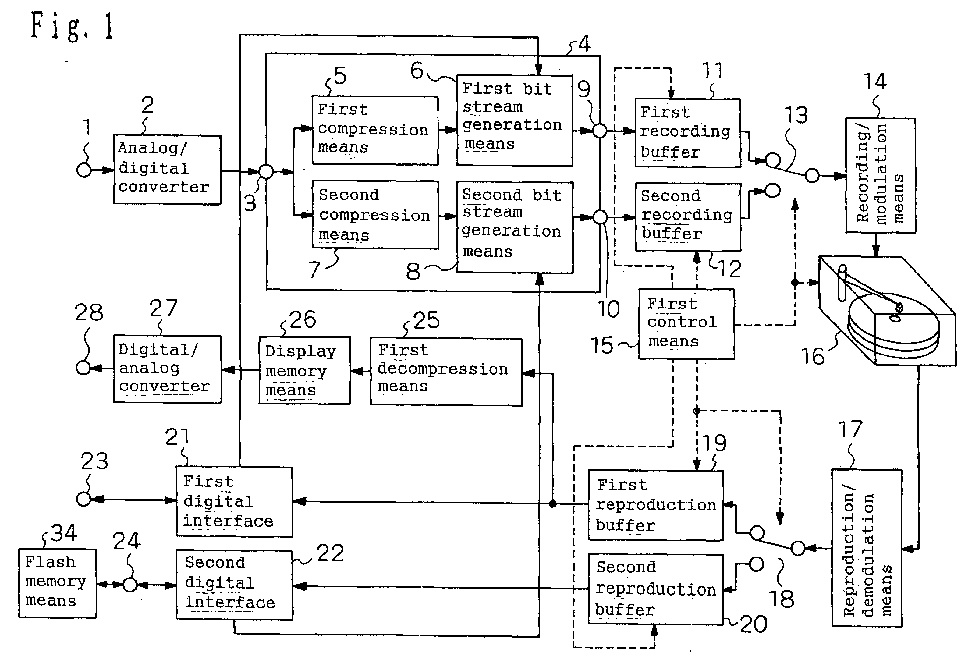

First, referring to FIG. 1 serving as a block diagram of a recording/reproducing apparatus in accordance with Embodiment 1 of the present invention, the configuration of the recording/reproducing apparatus in accordance with this embodiment will be described.

As detailed below, in accordance with this embodiment, by using a low-rate compression stream being recorded simultaneously with a high-rate compression stream, animated images can be carried by using a removable low-capacity recording medium, which was impossible conventionally.

In FIG. 1, numeral 1 designates an analog input terminal to which an analog video signal (hereafter, including an audio signal) is input. Numeral 2 designates an analog/digital converter that converts the analog signal input from the analog input terminal 1 into a digital signal. Numeral 4 designates a compression stream generation means comprising an input terminal 3, a first compression means 5, a first bit stream generation means 6, an output terminal 9, a second compression means 7, a second bit stream generation means 8 and an output terminal 10. Numeral 11 designates a first recording buffer that temporarily stores a first bit stream. Numeral 12 designates a second recording buffer that temporarily stores a second bit stream. Numeral 13 designates a switch that selects one of the outputs of the recording buffers 11 and 12. Numeral 14 designates a recording/modulation means that appropriately modulates the recorded stream so as to be recorded and reproduced by a disk-shaped recording apparatus 16. Numeral 17 designates a reproduction/demodulation means that demodulates the modulation carried out during recording by the recording/modulation means 14. Numeral 18 designates a switch that distributes the reproduced stream to a first reproduction buffer 19 and a second reproduction buffer 20. Numeral 15 designates a first control means that controls the reading/writing timing of the buffers 11, 12, 19 and 20 and the recording/reproduction timing of the disk-shaped recording apparatus 16 to attain synchronization. Numeral 25 designates a first decompression means that decompresses an image from the first bit stream generated by the compression stream generation means 4. Numeral 26 designates a display memory that stores the image in frame units and carries out output to a digital/analog converter 27. Numeral 28 designates an analog output terminal that outputs the reproduced analog image. Numeral 21 designates a first digital interface that inputs/outputs the first bit stream. Numeral 23 designates a first digital input/output terminal. Numeral 22 designates a second digital interface that inputs/outputs the second bit stream. Numeral 24 designates a second digital input/output terminal. Numeral 34 designates a flash memory means connected to the second digital input/output terminal.

The means including the compression stream generation means 4 corresponds to the means including the generation means of the present invention; the means including the recording/modulation means 14 corresponds to the means including the recording means of the present invention; the means including the first digital interface 21 corresponds to the means including the first bit stream output means of the present invention; and the means including the second digital interface 22 corresponds to the means including the second bit stream output means of the present invention. In addition, the recording/reproducing apparatus of this embodiment corresponds to the recording apparatus of the present invention.

Next, the operations of the recording/reproducing apparatus of this embodiment will be described. While the operations of the recording/reproducing apparatus of this embodiment are described, an example of a recording method and an example of a recording/reproducing method of the present invention will also be described (also applicable to the following embodiments).

A video signal (luminance signal Y and color difference signals Cb and Cr) input from the analog input terminal 1 is converted into a digital signal by the analog/digital converter 2. When Y:Cr:Cb = 4:2:2 is subjected to 8-bit,14.3 MHz sampling, the total bit rate is about 230 Mbps.

This digital signal is first input to the compression stream generation means 4 and converted into two kinds, first and second, of compression bit streams by using the first compression means 5/the first bit stream generation means 6 and by using the second compression means 7/the second bit stream generation means 8.

The first bit stream is a high bit-rate stream, and the second bit stream is a low bit-rate stream; these streams can independently reconstruct images. For example, the first compression means is a means that carries out compression of about 3 Mbps to 12 Mbps by using the MPEG2 compression, the standard of the current broadcasting system, and the second compression means is a means that carries out compression of about 32 Kbps to 384 Kbps by using the MPEG4 compression to attain a higher compression rate.

As described above, this embodiment has the means that carry out two kinds of compression, being different in bit rate by several tens to about 100 times.

The data compressed by the first and second compression means 5 and 7 are then input to the first and second bit stream generation means 6 and 8, thereby becoming streams to which a recording header and an error correction code are added, and being output to the output terminals 9 and 10, respectively. The respective streams are stored once in the first and second recording buffers 11 and 12, passed through the switch 13, modulated appropriately for recording/reproduction by the recording/modulation means 14, and then recorded on the disk-shaped recording apparatus 16.

Numeral 15 designates the first control means that synchronously controls the timing of the reading' at the first and second recording buffers, the switching at the switch 13 and the recording at the disk-shaped recording apparatus 16. In this way, the first bit stream and the second bit stream are recorded on the disk-shaped recording apparatus 16 without any dropout.

During reproduction, when the first stream is reproduced, for example, the switch 18 is set to the side of the first reproduction buffer 19, and the first control means is used to synchronously control the reading timing of the first stream from the disk-shaped recording apparatus 16 and the writing timing of the first reproduction buffer 19, thereby writing to the first reproduction buffer 19. When the second stream is reproduced, the switch 18 is set to the side of the second reproduction buffer 20, and the first control means is used to synchronously control the reading timing of the second stream from the disk-shaped recording apparatus 16 and the writing timing of the first reproduction buffer 20, thereby writing to the second reproduction buffer 20.

At this time, by appropriately carrying out timing control at the first control means, while the first and second streams are written, both the streams can be reproduced simultaneously or other streams having been recorded can be reproduced

The first stream read by the first reproduction buffer 19 is decompressed to the image obtained before the compression by the first decompression means 25 and stored in frame units in the display memory means 26, and the reproduced image is output to the analog output terminal 28 via the digital/analog converter 27. Since this image is based on MPEG2 having a high rate, it has a sufficient quality when received on a home-use large-screen TV set.

In addition, the first reproduction buffer 19 carries out output to the first digital input/output terminal 23 via the first digital interface 21. This terminal is used for digital connection to another AV apparatus (for example, STB). The first digital interface 21 is formed of, for example, an IEEE1394 serial bus or the like as the standard; however, other interface means may also be used.

The second reproduction buffer 20 carries out output to the second digital input/output terminal 24 via the second digital interface 22. Low-rate images obtained by MPEG4 compression can be written to the removable flash memory means 34 connected to this terminal.

The flash memory means 34 is available as, for example, a compact flash, a smart medium, an SD card, a memory stick or the like. If the capacity of the flash memory means 34 is 64 MB and the MPEG4 stream has 128 Kbps, animated image data of about one hour can be recorded. By carrying this flash memory means 34 and a compact reproducing apparatus, such as a PDA, reception is possible in the open air or the like.

In this way, in accordance with this embodiment, by using a low-rate compression stream being recorded simultaneously with a high-rate compression stream, animated images can be carried by using removable low-capacity recording media.

Furthermore, by using the first and second digital input/output terminals 23 and 24 as input terminals, the respective first and second compressed digital images can also be recorded on the disk-shaped recording apparatus 16. The respective streams have been input to the first and second bit stream generation means in the compression bit stream generation means 4 via the first and second digital interfaces 21 and 22; in the present invention, compressed digital images can also be input externally and then recorded and reproduced.

### (Embodiment 2)

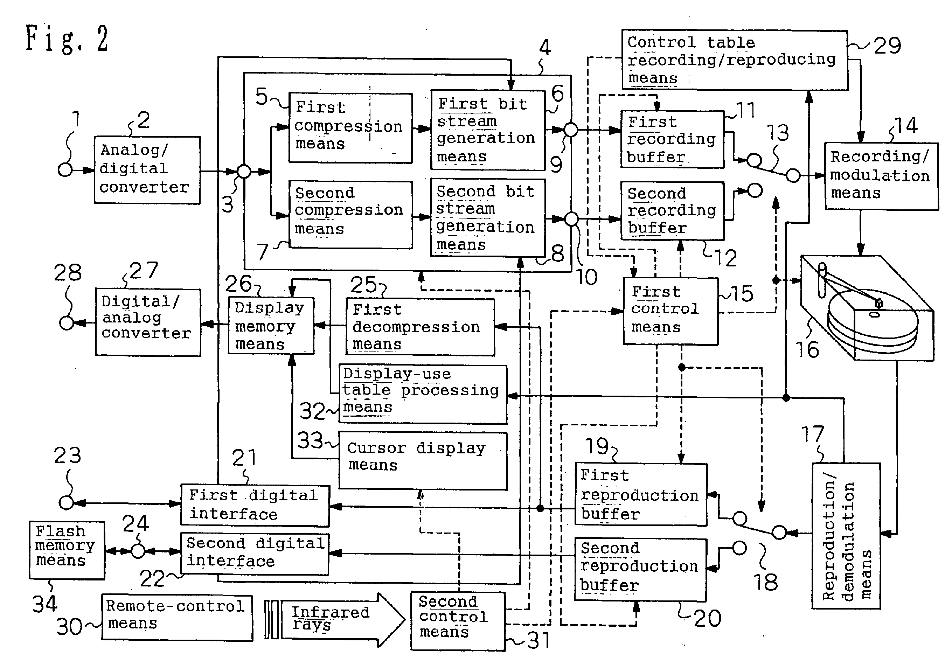

Next, referring to FIG. 2 serving as a block diagram of a recording/reproducing apparatus in accordance with Embodiment 2 of the present invention, the configuration of the recording/reproducing apparatus in accordance with this embodiment will be described.

As detailed below, in accordance with this embodiment, in addition to the effects of Embodiment 1 described above, by using screen display, a second bit stream can be recorded easily in'a flash memory.

In FIG. 2, numeral 1 designates an analog input terminal to which an analog video signal (hereafter, including an audio signal) is input. Numeral 2 designates an analog/digital converter that converts the analog signal input from the analog input terminal 1 into a digital signal. Numeral 4 designates a compression stream generation means comprising an input terminal 3, a first compression means 5, a first bit stream generation means 6, an output terminal 9, a second compression means 7, a second bit stream generation means 8 and an output terminal 10. Numeral 11 designates a first recording buffer that temporarily stores a first bit stream. Numeral 12 designates a second recording buffer that temporarily stores a second bit stream. Numeral 13 designates a switch that selects one of the outputs of the recording buffers 11 and 12. Numeral 14 designates a recording/modulation means that appropriately modulates the recorded stream so as to be recorded and reproduced by a disk-shaped recording apparatus 16. Numeral 17 designates a reproduction/demodulation means that demodulates the modulation carried out during recording by the recording/modulation means 14. Numeral 18 designates a switch that distributes the reproduced stream to a first reproduction buffer 19 and a second reproduction buffer 20. Numeral 15 designates a first control means that controls the reading/writing timing of the buffers 11, 12, 19 and 20 and the recording/reproduction timing of the disk-shaped recording apparatus 16 to attain synchronization. Numeral 25 designates a first decompression means that decompresses an image from the first bit stream generated by the compression stream generation means 4. Numeral 26 designates a display memory that stores the image in frame units and carries out output to a digital/analog converter 27. Numeral 28 designates an analog output terminal that outputs the reproduced analog image. Numeral 21 designates a first digital interface that inputs/outputs the first bit stream. Numeral 23 designates a first digital input/output terminal. Numeral 22 designates a second digital interface that inputs/outputs the second bit stream. Numeral 24 designates a second digital input/output terminal. Numeral 34 designates a flash memory means connected to the second digital input/output terminal.

In addition, in this embodiment, numeral 29 designates a means of recording and reproducing a control table representing the recorded contents of the disk-shaped recording/reproducing apparatus 16, numeral 30 designates a remote-control means of externally controlling the recording/reproducing apparatus, numeral 31 designates a control means of controlling screen display, compression rate and recording/reproduction on the basis of the instructions from the remote-control means 31, numeral 32 designates a display-use table processing means of displaying the control table, which is recorded on the disk-shaped recording/reproducing apparatus 16, on the screen, and numeral 33 designates a cursor display means of displaying a cursor on the screen on the basis of the instructions from the second control means 31.

The means including the display-use table processing means 32 corresponds to the means including the display means of the present invention, and the means including the cursor display means 33 corresponds to the means including the selection means of the present invention.

Next, the operations of the recording/reproducing apparatus of this embodiment will be described.

A video signal (luminance signal Y and color difference signals Cb and Cr) input from the analog input terminal 1 is converted into a digital signal by the analog/digital converter 2. When Y:Cr:Cb = 4:2:2 is subjected to 8-bit, 14.3 MHz sampling, the total bit rate is about 230 Mbps. This digital signal is first input to the compression stream generation means 4 and converted into two kinds, first and second, of compression bit streams by using the first compression means 5/the first bit stream generation means 6 and by using the second compression means 7/the second bit stream generation means 8. The first bit stream is a high bit-rate stream, and the second bit stream is a low bit-rate stream; these streams can reconstruct images independently. For example, the first compression means is a means that carries out compression of about 3 Mbps to 12 Mbps by using the MPEG2 compression, the standard of the current broadcasting system, and the second compression means is a means that carries out compression of about 32 Kbps to 384 Kbps by using the MPEG4 compression to attain a higher compression rate. As described above, this embodiment has the means that carry out two kinds of compression, being different in bit rate by several tens to about 100 times.

The data compressed by the first and second compression means 5 and 7 are then input to the first and second bit stream generation means 6 and 8, thereby becoming streams to which a recording header and an error correction code are added, and being output to the output terminals 9 and 10, respectively. The respective streams are stored once in the first and second recording buffers 11 and 12, passed through the switch 13, modulated appropriately for recording/reproduction by the recording/modulation means 14, and then recorded on the disk-shaped recording apparatus 16. Numeral 15 designates the first control means that synchronously controls the timing of the reading at the first and second recording buffers, the switching at the switch 13 and the recording at the disk-shaped recording apparatus 16. In this way, the first bit stream and the second bit stream are recorded on the disk-shaped recording apparatus 16 without any dropout.

Furthermore, in this embodiment, the control table recording/reproduction means 29 gives instructions to the first control means and delivers a control table that unifies the management of the recorded contents at the same time, and the control table is recorded in a specific area of the disk-shaped recording/reproducing apparatus 16.

During reproduction, when the first stream is reproduced, for example, the switch 18 is set to the side of the first reproduction buffer 19, and the first control means is used to synchronously control the reading timing of the first stream from the disk-shaped recording apparatus 16 and the writing timing of the first reproduction buffer 19, thereby writing the stream to the first reproduction buffer 19. When the second stream is reproduced, the switch 18 is set to the side of the second reproduction buffer 20, and the first control means is used to synchronously control the reading timing of the second stream from the disk-shaped recording apparatus 16 and the writing timing of the first reproduction buffer 20, thereby writing the stream to the second reproduction buffer 20.

At this time, by appropriately carrying out timing control at the first control means, while the first and second streams are written, both the streams can be reproduced simultaneously or other streams having been recorded can be reproduced

The first stream read by the first reproduction buffer 19 is decompressed to the image obtained before the compression by the first decompression means 25 and stored in frame units in the display memory means 26, and the reproduced image is output to the analog output terminal 28 via the digital/analog converter 27. Since this image is based on MPEG2 having a high rate, it has a sufficient quality when received on a home-use large-screen TV set.

In addition, the first reproduction buffer 19 carries out output to the first digital input/output terminal 23 via the first digital interface 21. This terminal is used for digital connection to another AV apparatus (for example, STB). The first digital interface 21 is formed of, for example, an IEEE1394 serial bus or the like, as the standard; however, other interface means may also be used.

The second reproduction buffer 20 carries out output to the second digital input/output terminal 24 via the second digital interface 22. Low-rate images obtained by MPEG4 compression can be written to the removable flash memory means 34 connected to this terminal. The flash memory means 34 is available as, for example, a compact flash, a smart medium, an SD card, a memory stick or the like. If the capacity of the flash memory means 34 is 64 MB and the MPEG4 stream has 128 Kbps, animated image data of about one hour can be recorded. By carrying this flash memory means 34 and a compact reproducing apparatus, such as a PDA, image reception is possible in the open air or the like.

In addition, in this embodiment, the remote-control means 30 is used to give instructions to the second control means 31 via wireless communication using infrared rays or the like. The second control means 31 gives instructions to the first control means 15 so that the recorded control table is read from the disk-shaped recording/reproducing apparatus. The control table having been read is passed through the reproduction/demodulation means 17 and is shaped into data for screen display by the display-use table processing means 32, whereby the control table is displayed on the display memory means.

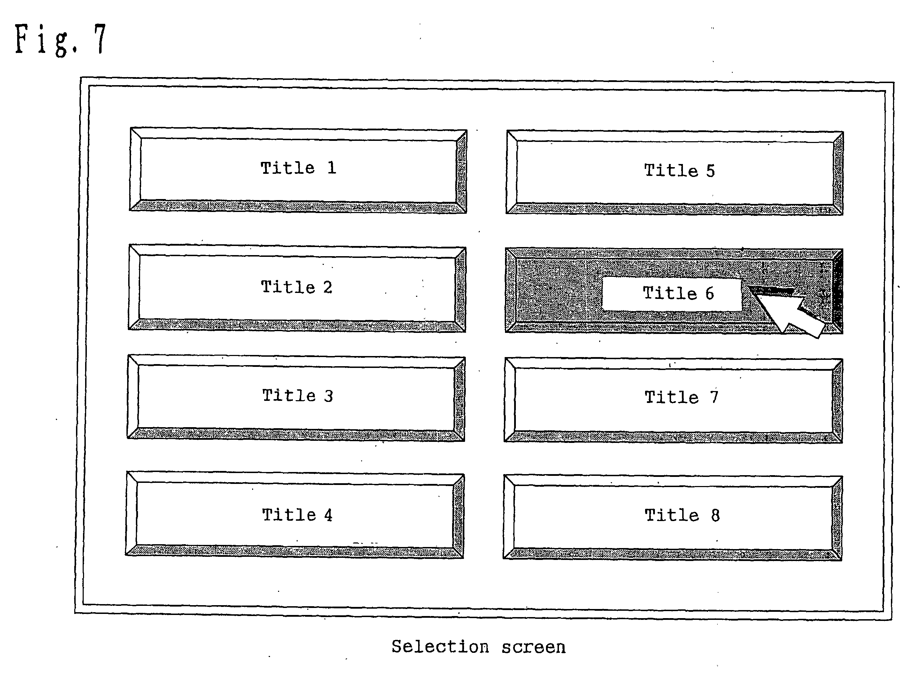

An example of screen configuration at the time is shown in FIG. 7, a conceptual view of a selection screen in accordance with Embodiment 2 of the present invention. FIG. 7 shows that the eight tiles of recorded contents are displayed.

The second control means 31 controls the cursor display means 33 to display a cursor on the screen. The displayed cursor is made movable by the remote-control means 30; the example in FIG. 7 shows that title 6 is selected. When a recorded title is selected by using the remote-control means 30 and screen display as described above, the second control means 31 gives instructions again to the first control means 15 at the same time, whereby the second bit stream having been recorded and corresponding to the selected title is reproduced and a low-rate stream is recorded in the flash memory means 34 via the second reproduction buffer 20, the second digital interface 22 and the second digital input/output terminal 24.

Furthermore, the second control means 31 also has a role of giving instructions regarding the compression rate and recording times to the compression stream generation means 4 during recording. These instructions, like the instructions regarding the transfer to the flash memory means 34 described above, are set via screen display by using the remote-control means 30.

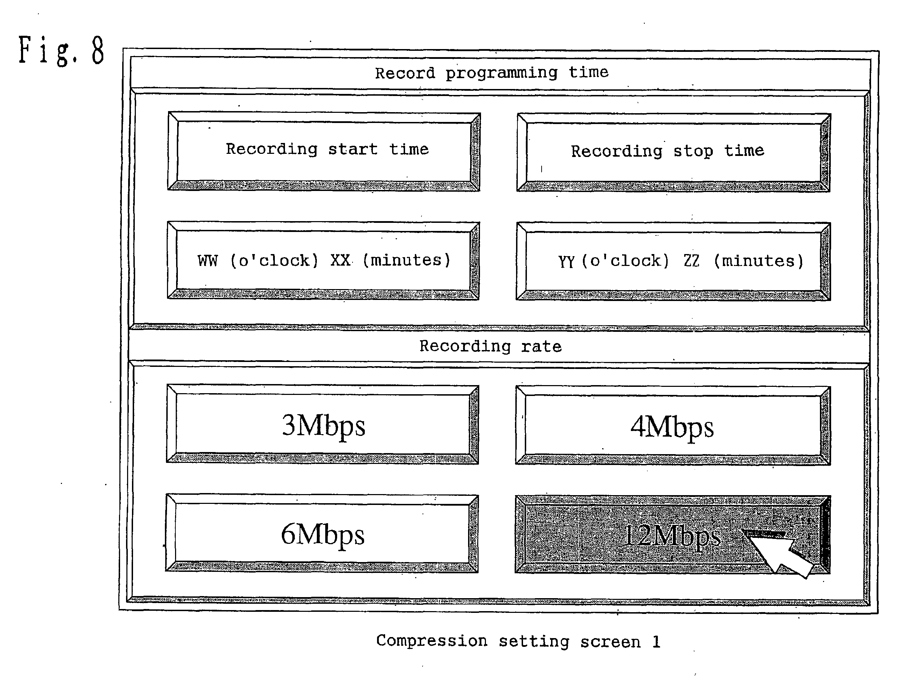

An example of screen configuration at the time is shown in FIG. 8, a conceptual view of compression setting screen 1 in accordance with Embodiment 2 of the present invention. FIG. 8 shows the compression setting screen 1; the upper area indicates recording times, and the lower area indicates compression rates during recording.

In this example, 12 Mbps is indicated since this is an example of setting the rate of the first bit stream, a high bit rate stream; the rate of the second bit stream, a low bit rate stream, is also instructed similarly. In this case, screen display is carried out at a low rate, such as 32 Kbps, 64 Kbps, 128 Kbps or 256 Kbps.

The second control means 31 gives instructions to the compression stream generation means 4 so that the rates of the first and second bit streams are controlled so as to be the above-mentioned rates. The compression stream generation means 4 generates a stream, the rate of which is controlled on the basis of the instructions.

Furthermore, in many cases, it is known in advance that the memory capacity of the flash memory means 32 is 32 MB, 64 MB, 128 MB or 256 MB, for example; the usability by the user is improved by controlling the rate of the second bit stream so as to match this capacity.

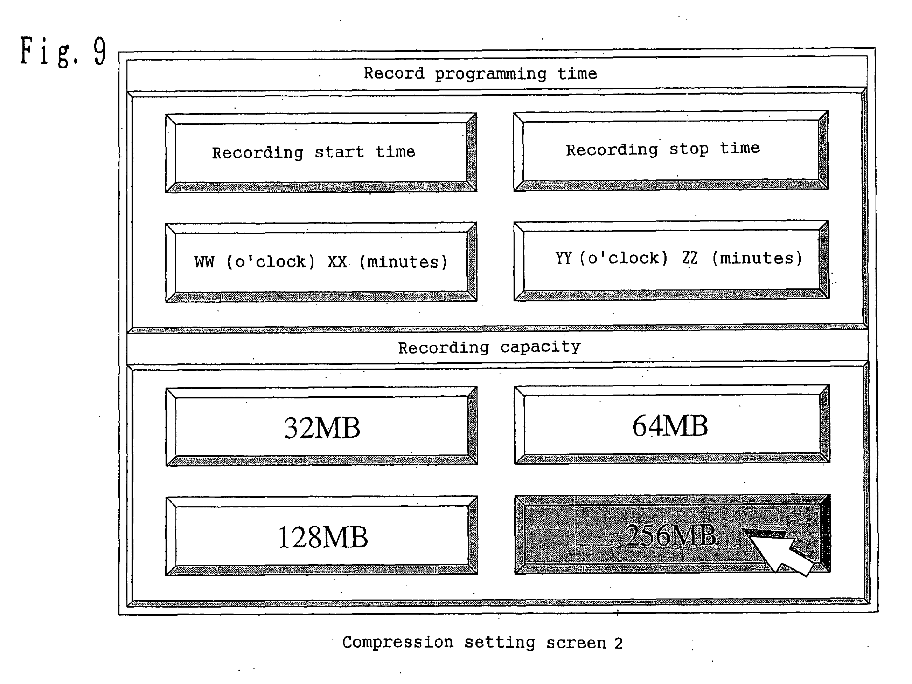

An example of screen configuration at the time is shown in FIG. 9, a conceptual view of compression setting screen 2 in accordance with Embodiment 2 of the present invention.

For example, in the method of designating the above-mentioned rate, in the case when a two-hour program is desired to be received by a flash memory of 256 MB, the user must calculates the recording rate (in this example, (256 x 2³ x 10³ Kb)/(2 x 3600 sec) = about 284 Kbps) and set the rate. In addition, in the case when the same recording rate as that of the result of the calculation cannot be set (for example, in the case when the rate of 284 Kbps obtained by the above-mentioned calculation cannot be selected, and only the settings of 32 Kbps, 64 Kbps, 128 Kbps, 256 Kbps and 384 Kbps are available, 256 Kbps is eventually selected), the flash memory means 34 cannot be used effectively.

In order to improve this kind of situation, in this embodiment, by giving instructions regarding the recording capacity and recording times, automatic control is carried out so that the rate exactly matches the recording capacity. In this example, the compression stream generation means 4 calculates the rate from the times and capacity on the basis of the instructions from the second control means 31 and automatically carries out rate control for 284 Kbps, thereby generating the second bit stream.

In this way, in this embodiment, in addition to the effects of Embodiment 1 described above, the second bit stream can be recorded easily in the flash memory by using the screen display.

Furthermore, by using the screen display, the instructions regarding the rate and times during compression can also be set easily, and by giving instructions regarding the recording capacity and recording times, the rate is controlled so as to exactly match the capacity of the flash memory; hence, it is not necessary for the user to carry out complicated calculations, whereby the usability is improved.

### (Embodiment 3)

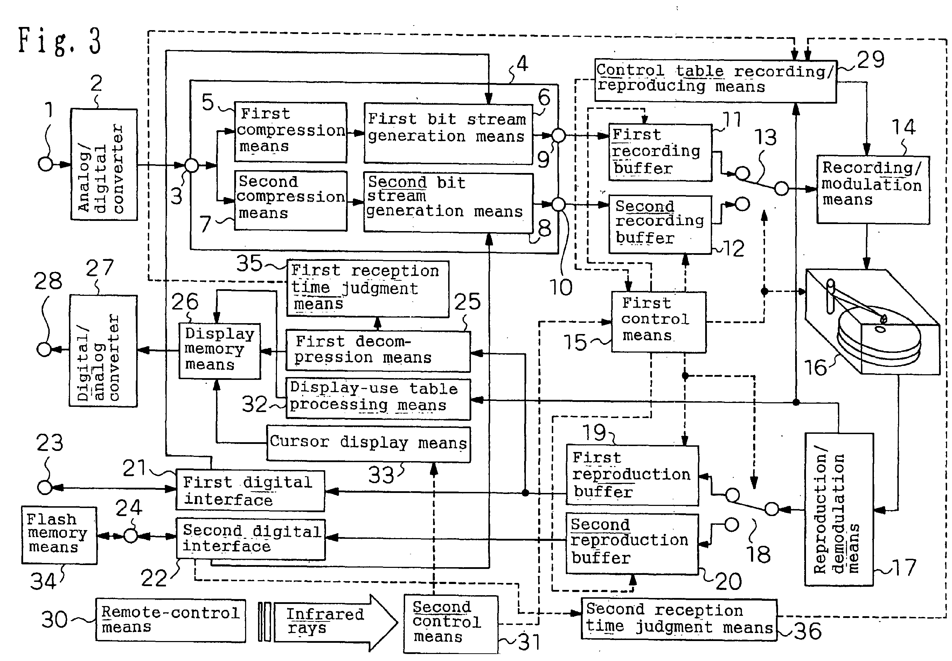

Next, referring to FIG. 3 serving as a block diagram of a recording/reproducing apparatus in accordance with Embodiment 3 of the present invention, the configuration of the recording/reproducing apparatus in accordance with this embodiment will be described.

As detailed below, in accordance with this embodiment, in addition to the effects of Embodiments 1 and 2 described above, when one stream was received halfway, only the continuation thereof can be received from the other stream by controlling the times when the first and second bit streams were received

In FIG. 3, numeral 1 designates an analog input terminal to which an analog video signal (hereafter, including an audio signal) is input. Numeral 2 designates an analog/digital converter that converts the analog signal input from the analog input terminal 1 into a digital signal. Numeral 4 designates a compression stream generation means comprising an input terminal 3, a first compression means 5, a first bit stream generation means 6, an output terminal 9, a second compression means 7, a second bit stream generation means 8 and an output terminal 10. Numeral 11 designates a first recording buffer that temporarily stores a first bit stream. Numeral 12 designates a second recording buffer that temporarily stores a second bit stream. Numeral 13 designates a switch that selects one of the outputs of the recording buffers 11 and 12. Numeral 14 designates a recording/modulation means that appropriately modulates the recorded stream so as to be recorded and reproduced by a disk-shaped recording apparatus 16. Numeral 17 designates a reproduction/demodulation means that demodulates the modulation carried out during recording by the recording/modulation means 14. Numeral 18 designates a switch that distributes the reproduced stream to a first reproduction buffer 19 and a second reproduction buffer 20. Numeral 15 designates a first control means that controls the reading/writing timing of the buffers 11, 12, 19 and 20 and the recording/reproduction timing of the disk-shaped recording apparatus 16 to attain synchronization. Numeral 25 designates a first decompression means that decompresses an image from the first bit stream generated by the compression stream generation means 4. Numeral 26 designates a display memory that stores the image in frame units and carries out output to a digital/analog converter 27. Numeral 28 designates an analog output terminal that outputs the reproduced analog image. Numeral 21 designates a first digital interface that inputs/outputs the first bit stream. Numeral 23 designates a first digital input/output terminal. Numeral 22 designates a second digital interface that inputs/outputs the second bit stream. Numeral 24 designates a second digital input/output terminal. Numeral 34 designates a flash memory means connected to the second digital input/output terminal.

In addition, in this embodiment, numeral 29 designates a means of recording and reproducing a control table representing the recorded contents of the disk-shaped recording/reproducing apparatus 16, numeral 30 designates a remote-control means of externally controlling the recording/reproducing apparatus of this embodiment, numeral 31 designates a control means of controlling screen display, compression rate and recording/reproduction on the basis of the instructions from the remote-control means 31, numeral 32 designates a display-use table processing means of displaying the control table, which is recorded on the disk-shaped recording/reproducing apparatus 16, on the screen, and numeral 33 designates a cursor display means of displaying a cursor on the screen on the basis of the instructions from the second control means 31. Numeral 35 designates a first reception time judgment means, and numeral 36 designates a second reception time judgment means.

The means including the first digital interface 21 corresponds to the means including the first bit stream output means of the present invention, and the means including the first reception time judgment means 35 and the second reception time judgment means 36 correspond to the means including the control means of the present invention.

Next, the operations of the recording/reproducing apparatus of this embodiment will be described.

A video signal (luminance signal Y and color difference signals Cb and Cr) input from the analog input terminal 1 is converted into a digital signal by the analog/digital converter 2. When Y:Cr:Cb = 4:2:2 is subjected to 8-bit, 14.3 MHz sampling, the total bit rate is about 230 Mbps. This digital signal is first input to the compression stream generation means 4 and converted into two kinds, first and second, of compression bit streams by using the first compression means 5/the first bit stream generation means 6 and by using the second compression means 7/the second bit stream generation means 8. The first bit stream is a high bit-rate stream, and the second bit stream is a low bit-rate stream; these streams can reconstruct images independently. For example, the first compression means is a means that carries out compression of about 3 Mbps to 12 Mbps by using the MPEG2 compression, the standard of the current broadcasting system, and the second compression means is a means that carries out compression of about 32 Kbps to 384 Kbps by using the MPEG4 compression to attain a higher compression rate. As described above, this embodiment has the means that carry out two kinds of compression, being different in bit rate by several tens to about 100 times.

The data compressed by the first and second compression means 5 and 7 are then input to the first and second bit stream generation means 6 and 8, thereby becoming streams to which a recording header and an error correction code are added, and being output to the output terminals 9 and 10, respectively. The respective streams are stored once in the first and second recording buffers 11 and 12, passed through the switch 13, modulated appropriately for recording/reproduction by the recording/modulation means 14, and then recorded on the disk-shaped recording apparatus 16. Numeral 15 designates the first control means that synchronously controls the timing of the reading at the first and second recording buffers, the switching at the switch 13 and the recording at the disk-shaped recording apparatus 16. In this way, the first bit stream and the second bit stream are recorded on the disk-shaped recording apparatus 16 without any dropout. Furthermore, the control table recording/reproduction means 29 gives instructions to the first control means and delivers a control table that unifies the management of the recorded contents at the same time, and the control table is recorded in a specific area of the disk-shaped recording/reproducing apparatus 16.

During reproduction, when the first stream is reproduced, for example, the switch 18 is set to the side of the first reproduction buffer 19, and the first control means is used to synchronously control the reading timing of the first stream from the disk-shaped recording apparatus 16 and the writing timing of the first reproduction buffer 19, thereby writing the stream to the first reproduction buffer 19. When the second stream is reproduced, the switch 18 is set to the side of the second reproduction buffer 20, and the first control means is used to synchronously control the reading timing of the second stream from the disk-shaped recording apparatus 16 and the writing timing of the first reproduction buffer 20, thereby writing the stream to the second reproduction buffer 20.

At this time, by appropriately carrying out timing control at the first control means, while the first and second streams are written, both the streams can be reproduced simultaneously or other streams having been recorded can be reproduced

The first stream read by the first reproduction buffer 19 is decompressed to the image obtained before the compression by the first decompression means 25 and stored in frame units in the display memory means 26, and the reproduced image is output to the analog output terminal 28 via the digital/analog converter 27. Since this image is based on MPEG2 having a high rate, it has a sufficient quality when received on a home-use large-screen TV set.

In addition, the first reproduction buffer 19 carries out output to the first digital input/output terminal 23 via the first digital interface 21. This terminal is used for digital connection to another AV apparatus (for example, STB). The first digital interface 21 is formed of, for example, an IEEE1394 serial bus or the like, as the standard; however, other interface means may also be used.

The second reproduction buffer 20 carries out output to the second digital input/output terminal 24 via the second digital interface 22. Low-rate images obtained by MPEG4 compression can be written to the removable flash memory means 34 connected to this terminal. The flash memory means 34 is available as, for example, a compact flash, a smart medium, an SD card, a memory stick or the like. If the capacity of the flash memory means 34 is 64 MB and the MPEG4 stream has 128 Kbps, animated image data of about one hour can be recorded. By carrying this flash memory means 34 and a compact reproducing apparatus, such as a PDA, image reception is possible in the open air or the like.

In addition, in this embodiment, the remote-control means 30 is used to give instructions to the second control means 31 via wireless communication using infrared rays or the like. The second control means 31 gives instructions to the first control means 15 so that the recorded control table is read from the disk-shaped recording/reproducing apparatus. The control table having been read is passed through the reproduction/demodulation means 17 and is shaped into data for screen display by the display-use table processing means 32, whereby the control table is displayed on the display memory means. An example of screen configuration at the time is shown in FIG. 7. FIG. 7 shows that the eight tiles of recorded contents are displayed. Furthermore, the second control means 31 controls the cursor display means 33 to display a cursor on the screen. The displayed cursor is made movable by the remote-control means 30; the example of FIG. 7 shows that title 6 is selected. When a recorded title is selected by using the remote-control means 30 and screen display as described above, the second control means 31 gives instructions again to the first control means 15 at the same time, whereby the second bit stream having been recorded and corresponding to the selected title is reproduced and a low-rate stream is recorded in the flash memory means 34 via the second reproduction buffer 20, the second digital interface 22 and the second digital input/output terminal 24.

Furthermore, the second control means 31 also has a role of giving instructions regarding the compression rate and recording times to the compression stream generation means 4 during recording. These instructions, like the instructions regarding the transfer to the flash memory means 34 described above, are set via screen display by using the remote-control means 30. FIG. 8 shows compression setting screen 1; the upper area indicates recording times, and the lower area indicates compression rates during recording. In this example, 12 Mbps is indicated since this is an example of setting the rate of the first bit stream, a high bit rate stream; the rate of the second bit stream, a low bit rate stream, is also instructed similarly. In this case, low rates, such as 32 Kbps, 64 Kbps, 128 Kbps and 256 Kbps, are indicated on the screen. The second control means 31 gives instructions to the compression stream generation means 4 so that the rates of the first and second bit streams are controlled so as to be the above-mentioned rates. The compression stream generation means 4 generates a stream, the rate of which is controlled on the basis of the instructions.

Furthermore, in many cases, it is known in advance that the memory capacity of the flash memory means 32 is 32, 64, 128 or 256 MB, for example; the usability by the user is improved by controlling the rate of the second bit stream so as to match this capacity. FIG. 9 is an example of screen display at the time.

For example, in the method of designating the above-mentioned rate, in the case when a two-hour program is desired to be received by a flash memory of 256 MB, the user must calculates the recording rate (in this example, 256 MB x 8/2 hours/3600 sec = about 284 Kbps) and set the rate. In addition, in the case when the same recording rate as that of the result of the calculation cannot be set (for example, in the case when the rate of 284 Kbps obtained by the above-mentioned calculation cannot be selected, and only the settings of 32 Kbps, 64 Kbps, 128 Kbps, 256 Kbps and 384 Kbps are available, 256 Kbps is eventually selected), the flash memory means 34 cannot be used effectively.

In order to improve this kind of situation, in this embodiment, by giving instructions regarding the recording capacity and recording times, automatic control is carried out so that the rate exactly matches the recording capacity. In this example, the compression stream generation means 4 calculates the rate from the times and capacity on the basis of the instructions from the second control means 31 and automatically carries out rate control for 284 Kbps, thereby generating the second bit stream.

In addition, in this embodiment, the first reception time judgment means 35 and the second reception time judgment means 36 are additionally.used to attain a function of establishing interconnection between the first bit stream and the second bit stream by utilizing the reception times of the user.

For example, it is assumed that the user is receiving the first bit stream just as in the cases of Embodiments 1 and 2 described above.

At this time, the first reception time judgment means 35 carries out monitoring to find out up to what part of which first bit stream has been received by the user. For example, it is assumed that the user received up to the two-hour part of a specific first bit stream having a length of three hours and stopped the reception. The first reception time judgment means 35 monitors this and provides notification regarding up to what part of which bit stream has been received, to the control table recording/reproduction means 29.

The control table recording/reproduction means 29 adds this information to the control table. In the case when the user receives the same stream later, reproduction automatically starts from the continuation part thereof (after the two-hour part).

In addition, in the case when an attempt is made to record, in a flash memory, a second bit stream corresponding to the first bit stream that was received halfway, only the continuation part (after the two-hour part) of the corresponding second bit stream is recorded automatically on the basis of the above-mentioned control table.

Furthermore, conversely, in the case when a specific second bit stream is received halfway in the open air by using a flash memory, when the flash memory is connected to the second digital input/output means 24, the second reception time judgment means 36 obtains information regarding up to what part has been received, from the flash memory, and gives instructions to the control table recording/reproducing means 29 and adds this information to the control table. In the case when the user receives the corresponding first stream later, the corresponding first stream is automatically reproduced from the continuation time part of the second bit stream having been received. At this time, the fact that up to what part of the second bit stream reproduced in the open air by the apparatus was received is assumed to have been recorded in the flash memory.

In this way, in accordance with this embodiment, in addition to the effects of Embodiments 1 and 2 described above, when one stream was received halfway, only the continuation thereof can be received from the other stream by controlling the times when the first and second bit streams were received

### (Embodiment 4)

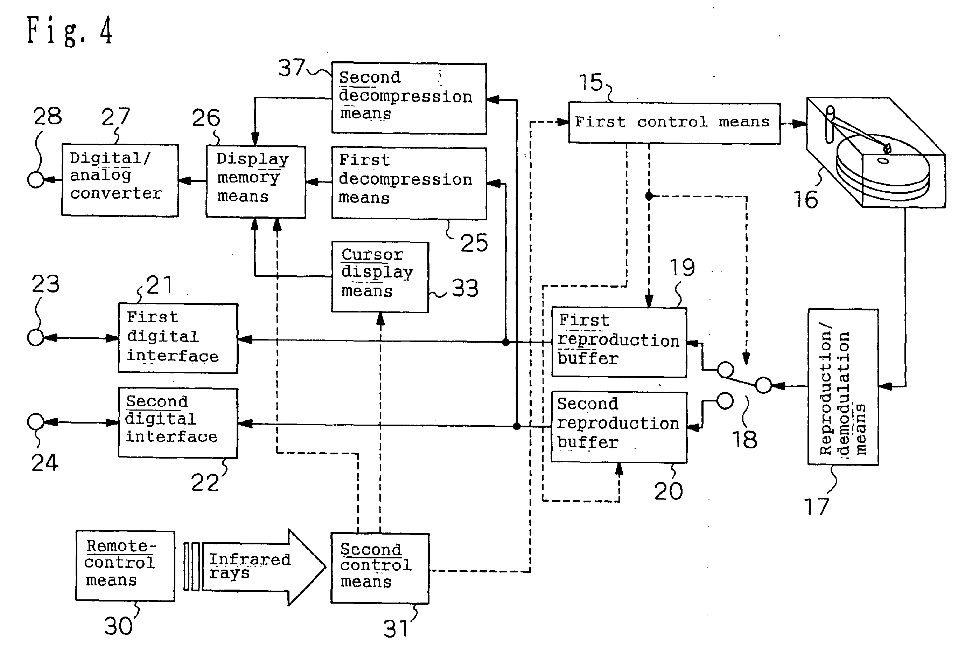

Next, referring to FIG. 4 serving as a block diagram of a recording/reproducing apparatus in accordance with Embodiment 4 of the present invention, the configuration of the recording/reproducing apparatus in accordance with this embodiment will be described (however, since the recording side is the same as those of Embodiments 1 to 3, only the reproduction side is shown in the figure for the sake of preventing complication).

As detailed below, in accordance with this embodiment, by simultaneously reproducing plural second bit streams (low rate) having been recorded, understanding the recorded contents is made easy; after a content that is desired to be received is selected by using the multi-screen thereof, the corresponding first bit stream having high image quality can be received.

In FIG. 4, numeral 16 designates a disk-shaped recording/reproducing apparatus, and numeral 17 designates a reproduction/demodulation means that demodulates the modulation carried out during recording. Numeral 18 designates a switch that distributes the reproduced stream to a first reproduction buffer 19 and a second reproduction buffer 20. Numeral 15 designates a first control means that controls the reading/writing timing of the buffers 19 and 20 and the recording/reproduction timing of the disk-shaped recording apparatus 16 to attain synchronization. Numeral 25 designates a first decompression means that decompresses an image from the first bit stream.

In addition, in this embodiment, numeral 37 designates a second decompression means that simultaneously decompresses plural images from the second bit stream.

Numeral 26 designates a display memory that stores the image in frame units and carries out output to a digital/analog converter 27. Numeral 28 designates an analog output terminal that outputs the reproduced analog image. Numeral 21 designates a first digital interface that inputs/outputs the first bit stream. Numeral 23 designates a first digital input/output terminal. Numeral 22 designates a second digital interface that inputs/outputs the second bit stream. Numeral 24 designates a second digital input/output terminal. Numeral 34 designates a flash memory means connected to the second digital input/output terminal. In addition, numeral 30 designates a remote-control means of externally controlling the recording/reproducing apparatus of this embodiment, numeral 31 designates a second control means of controlling screen display and reproduction on the basis of the instructions from the remote-control means 31, and numeral 33 designates a cursor display means of displaying a cursor on the screen on the basis of the instructions from the second control means 31.

The means including the second decompression means 37 corresponds to the means including the image display means of the present invention, and the means including the cursor display means 33 corresponds to the means including the selection means of the present invention.

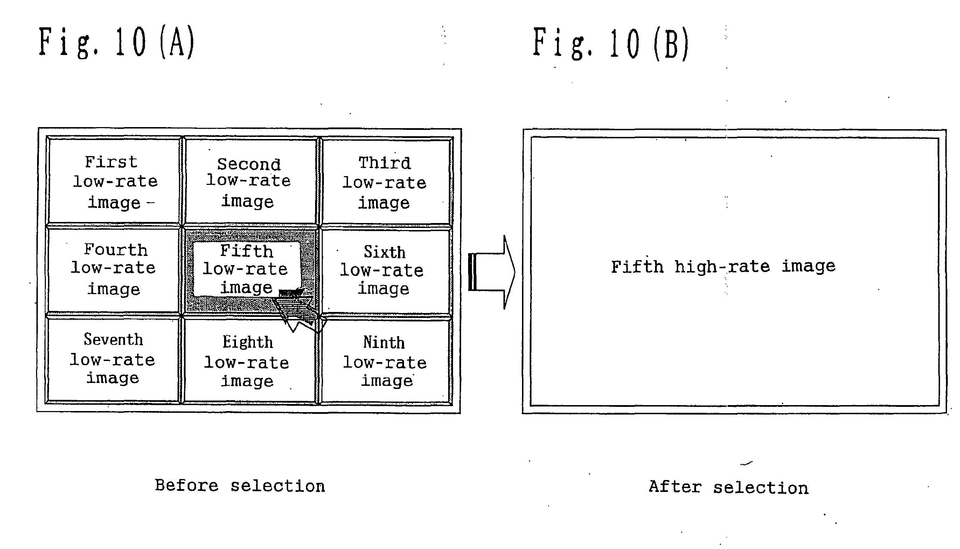

Next, the operations of the recording/reproducing apparatus of this embodiment will be described by mainly referring to FIG. 10 (a) serving as a conceptual view of an image multi-screen (before selection) in accordance with Embodiment 4 of the present invention and FIG. 10 (b) serving as a conceptual view of an image screen (after selection) in accordance with Embodiment 4 of the present invention.

In this embodiment, the second decompression means 37 is used to simultaneously decode plural second bit streams, thereby forming a multi-screen (in FIG. 10 (a), nine screens, first to ninth, are displayed).

In the steps of displaying the plural screens, the switch 18 is set to the side of the second reproduction buffer 20 by the first control means 15, and the control means 15 is used to synchronously control the reading timing of the plural second bit streams from the disk-shaped recording apparatus 16 and the writing timing of the second reproduction buffer 20, thereby writing the plural second bit streams to the second reproduction buffer 20.

Next, the plural second bit streams read by the second reproduction buffer 20 are simultaneously decompressed to plural screens by the second decompression means 37. The plural screens are written to the display memory means 26, and reproduced images are output to the analog output terminal 28 via the digital/analog converter 27.

Unlike the first bit stream, the second bit streams are not high-rate streams; therefore, this kind of simultaneous reproduction can be attained. For example, when nine first streams of 6 Mbps are reproduced, the disk-shaped recording/reproducing apparatus 16 is required to have the reproduction capability of 54 Mbps; however, in the case of the second streams of 128 Kbps, even if nine second streams are reproduced, stream reproduction of 1.152 Mbps is required; this can be attained easily.

In this way, in this embodiment, by using the second bit streams, multi-screen reproduction can be attained easily, whereby the recorded contents can be understood easily.

Furthermore, by using the remote-control means 30, the second control means 31 and the cursor display means 33, a screen that is desired to be received on a large screen can be selected easily from plural screens having been displayed. After the selection, the disk-shaped recording apparatus 16 is controlled by the first control means 15 so as to read the corresponding first stream, whereby the corresponding first stream is decompressed and reproduced.

More specifically, the fifth low-rate image is selected in FIG. 10 (a), and the corresponding fifth high-rate image is reproduced in FIG. 10 (b).

In this way, in accordance with this embodiment, by simultaneously reproducing plural second bit streams (low rate) having been recorded, understanding the recorded contents is made easy; after a content that is desired to be received is selected by using the multi-screen thereof, the corresponding first bit stream having high image quality can be received.

### (Embodiment 5)

Next, the configuration of a recording/reproducing apparatus in accordance with this embodiment will be described.

As detailed below, in accordance with this embodiment, it is possible to easily attain the checking of recorded contents on small screens while a high-quality image is watched on a large screen.

The recording/reproducing apparatus in accordance with this embodiment has a configuration similar to that of the recording/reproducing apparatus (see FIG. 4) in accordance with Embodiment 4 described above. In other words, in FIG. 4, numeral 16 designates a disk-shaped recording/reproducing apparatus, and numeral 17 designates a reproduction/demodulation. means that demodulates the modulation carried out during recording. Numeral 18 designates a switch that distributes the reproduced stream to a first reproduction buffer 19 and a second reproduction buffer 20. Numeral 15 designates a first control means that controls the reading/writing timing of the buffers 19 and 20 and the recording/reproduction timing of the disk-shaped recording apparatus 16 to attain synchronization. Numeral 25 designates a first decompression means that decompresses an image from the first bit stream. Numeral 37 designates a second decompression means that simultaneously decompresses plural images from the second bit stream. Numeral 26 designates a display memory that stores the image in frame units and carries out output to a digital/analog converter 27. Numeral 28 designates an analog output terminal that outputs the reproduced analog image. Numeral 21 designates a first digital interface that inputs/outputs the first bit stream. Numeral 23 designates a first digital input/output terminal. Numeral 22 designates a second digital interface that inputs/outputs the second bit stream. Numeral 24 designates a second digital input/output terminal. Numeral 34 designates a flash memory means connected to the second digital input/output terminal. In addition, numeral 30 designates a remote-control means of externally controlling the recording/reproducing apparatus of this embodiment, numeral 31 designates a second control means of controlling screen display and reproduction on the basis of the instructions from the remote-control means 31, and numeral 33 designates a cursor display means of displaying a cursor on the screen on the basis of the instructions from the second control means 31.

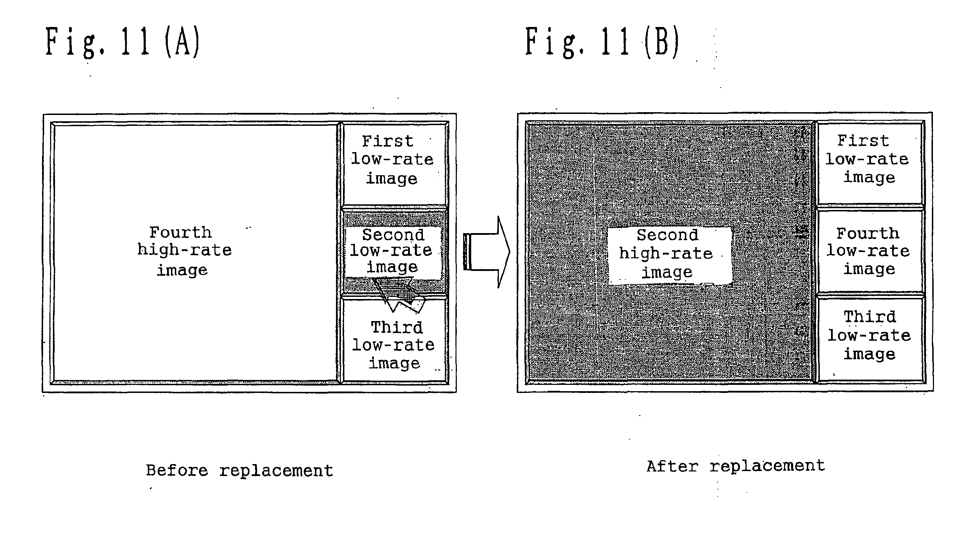

Next, the operations of the recording/reproducing apparatus of this embodiment will be described by mainly referring to FIG. 11 (a) serving as a conceptual view of an image multi-screen (before replacement) in accordance with Embodiment 5 of the present invention and FIG. 11 (b) serving as a conceptual view of an image screen (after replacement) in accordance with Embodiment 5 of the present invention.

In this embodiment, the first and second decompression means 25 and 37 are used to simultaneously decode a first bit stream and plural second bit streams, thereby forming a multi-screen (in FIG. 11 (a), a first bit stream (corresponding to the fourth high-rate image in the figure) and three second streams (corresponding to the first, second and third low-rate images in the figure) are displayed simultaneously).

In'the steps of displaying the plural screens, the one first stream and the plural second streams are decompressed simultaneously by combining the above-mentioned procedures.

With respect to the first stream, the switch 18 is set to the side of the first reproduction buffer 19 by the first control means 15, and the control means 15 is used to synchronously control the reading timing of the first bit stream from the disk-shaped recording apparatus 16 and the writing timing of the first reproduction buffer 19, thereby writing the first bit stream to the first reproduction buffer 19.

Next, the first bit stream read by the first reproduction buffer 19 is decompressed to a screen by the first decompression means 25. The screen is then written to the display memory means 26.

With respect to the second streams, the switch 18 is set to the side of the second reproduction buffer 20 by the first control means, and the control means 15 is used to synchronously control the reading timing of the plural second bit streams from the disk-shaped recording apparatus 16 and the writing timing of the second reproduction buffer 20, thereby writing the plural second bit streams to the second reproduction buffer 20.

Next, the plural second bit streams read by the second reproduction buffer 20 are decompressed simultaneously to plural screens by the second decompression means 37. The plural screens are written to the display memory means 26.

The screen in FIG. 11 (a) can be reproduced by appropriately controlling the position of writing to the display memory means 26.

In the end, a reproduced image is output to the analog output terminal 28 via the digital/analog converter 27.

Next, this screen can be easily replaced between a large screen and a small screen by using the remote-control means 30.

More specifically, when a second low-rate image is selected in FIG. 11 (a), a fourth high-rate image is replaced with the second low-rate image as shown in FIG. 11 (b). At this time, the second high-rate image is reproduced on the large screen, and the fourth low-rate image is reproduced on a small screen. This can be attained by replacing streams to be reproduced, by using the first control means 15.

As described above, in accordance with this embodiment, checking recorded contents on the small screens while watching a high-quality image on the large screen can be attained easily.

Furthermore, by replacing reproduced streams, screen replacement can be carried out easily; a high-rate stream is reproduced on the large screen, and low-rate streams are reproduced on the small screens, whereby satisfactory reproduction in image quality can also be obtained.

### (Embodiment 6)

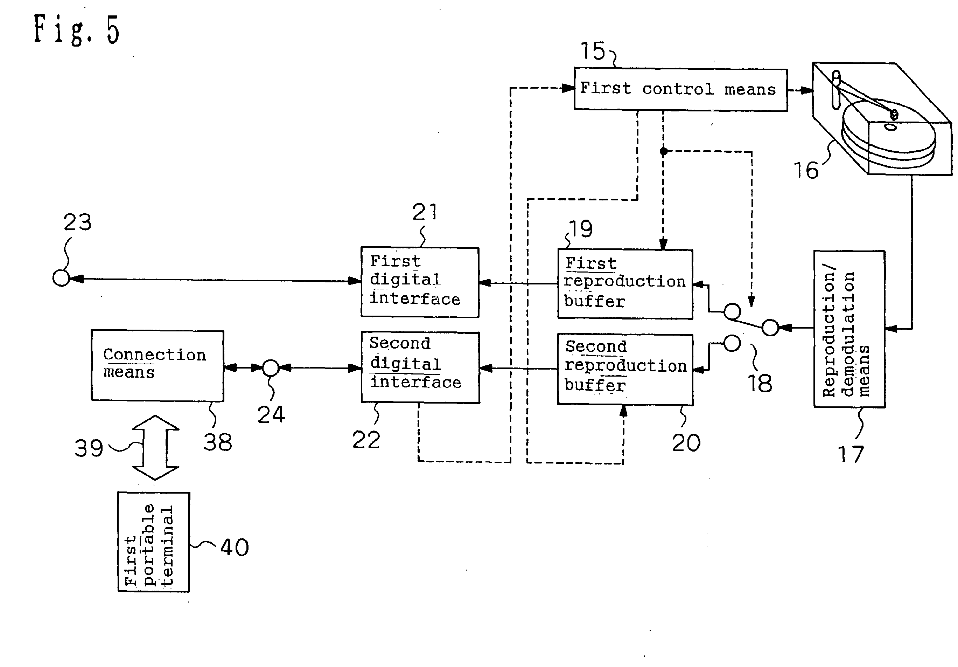

Next, referring to FIG. 5 serving as a block diagram of a recording/reproducing apparatus in accordance with Embodiment 6 of the present invention, the configuration of the recording/reproducing apparatus in accordance with this embodiment will be described (however, only the reproduction side is shown in the figure for the sake of preventing complication).

As detailed below, in accordance with this embodiment, image reception is possible through public circuits from remote sites.

In FIG. 5, numeral 16 designates a disk-shaped recording/reproducing apparatus, and numeral 17 designates a reproduction/demodulation means that demodulates the modulation carried out during recording. Numeral 18 designates a switch that distributes the reproduced stream to a first reproduction buffer 19 and a second reproduction buffer 20. Numeral 15 designates a first control means that controls the reading/writing timing of the buffers 19 and 20 and the recording/reproduction timing of the disk-shaped recording apparatus 16 to attain synchronization. Numeral 21 designates a first digital interface that inputs/outputs the first bit stream. Numeral 23 designates a first digital input/output terminal. Numeral 22 designates a second digital interface that inputs/outputs the second bit stream. Numeral 24 designates a second digital input/output terminal.

In addition, in this embodiment, numeral 38 designates a connection means to public circuits, numeral 39 designates wireless communication, and numeral 40 designates a first portable terminal.

Next, the operations of the recording/reproducing apparatus of this embodiment will be described.

In this embodiment, instead of the above-mentioned flash memory, the connection means to public circuits is connected to the second digital input/output terminal 24. For example, this is a modem used for connection to public telephone lines.

The first portable terminal is, for example, a portable terminal with a built-in PHS. Hence, by wireless connection between the recording/reproducing apparatus of the present invention and the portable terminal, the recorded second bit stream can be received from remote sites.

By setting the second bit stream so as to have a rate approximately close to PIAFS (32 Kbps, 64 Kbps) of the data transfer system of the PHS, for example, reception can be attained.

As described above, in accordance with this embodiment, image reception is possible through public circuits from remote sites.

### (Embodiment 7)

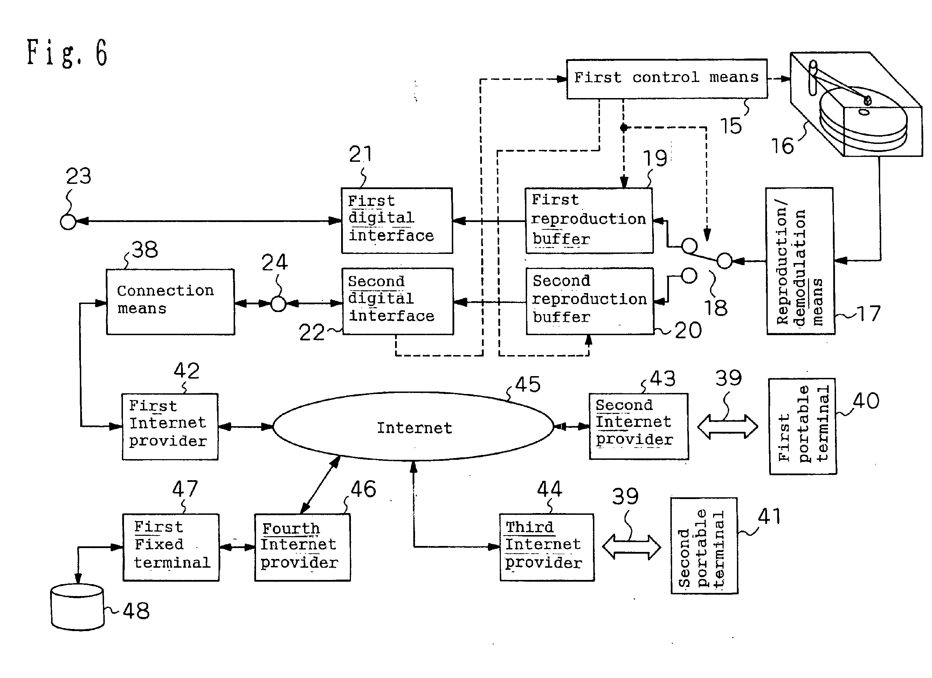

Next, referring to FIG. 6 serving as a block diagram of a recording/reproducing apparatus in accordance with Embodiment 7 of the present invention, the configuration of the recording/reproducing apparatus in accordance with this embodiment will be described (herein, only the reproduction side is also shown in the figure for the sake of preventing complication).

As detailed below, in accordance with this embodiment, image reception is possible from plural portable terminals through public circuits from remote sites.

In FIG. 6, numeral 16 designates a disk-shaped recording/reproducing apparatus, and numeral 17 designates a reproduction/demodulation means that demodulates the modulation carried out during recording. Numeral 18 designates a switch that distributes the reproduced stream to a first reproduction buffer 19 and a second reproduction buffer 20. Numeral 15 designates a first control means that controls the reading/writing timing of the buffers 19 and 20 and the recording/reproduction timing of the disk-shaped recording apparatus 16 to attain synchronization. Numeral 21 designates a first digital interface that inputs/outputs the first bit stream. Numeral 23 designates a first digital input/output terminal. Numeral 22 designates a second digital interface that inputs/outputs the second bit stream. Numeral 24 designates a second digital input/output terminal.

In addition, in this embodiment, numeral 38 designates a connection means to public circuits, numeral 39 designates wireless communication, numerals 40 and 41 designate portable terminals, numeral 47 designates a fixed terminal, and numeral 48 designates a recording apparatus. Numerals 42, 43, 44 and 46 designate Internet providers, and numeral 45 designates the Internet.

Next, the operations of the recording/reproducing apparatus of this embodiment will be described.

In this embodiment, instead of the above-mentioned flash memory, the connection means 38 to public circuits is connected to the second digital input/output terminal 24. For example, this is a modem used for connection to public telephone lines.

The first and second portable terminals 40 and 41 are, for example, portable terminals with built-in PHSs. These connection means and portable terminals are connected to the Internet via the Internet providers 42, 43 and 44. Hence, by wireless connection (PHS) between the recording/reproducing apparatus of the present invention and the plural portable terminals, recorded second bit streams can be received from remote sites by the plural portable terminals. In this case, it is also possible to receive an image being different for each portable terminal.

Furthermore, in the case when the fixed terminal 47 connected to the recording apparatus 48 having a large capacity is connected to the Internet via the Internet provider 46, reception is also possible by accessing the second bit streams of the recording/reproducing apparatus via the Internet, by selecting a stream, and by downloading the corresponding first bit stream to the recording apparatus 48. In this case, the first bit stream should only be output to the system that is originally used to output the second bit streams, by setting the switch 18 to the side of the second reproduction buffer 20 so that the first bit stream having been recorded on the disk-shaped recording apparatus 16 is output to the second digital input/output terminal 24 (in this case, the system that is originally used to output the second bit streams is used for connection to public circuits).

As described above, in accordance with this embodiment, image reception is possible from the plural portable terminals through public circuits from remote sites.

In addition, if a large-capacity recording apparatus is connected to the terminal, the first bit stream can be downloaded from a remote site, whereby high-quality images can be received.

In the above descriptions, Embodiments 1 to 7 are explained in detail.

The present invention includes a program that carries out the functions of all or part of the means (or apparatuses, devices, circuits, portions, etc.) of the above-mentioned recording apparatus of the present invention by using a computer and operates in cooperation with the computer. The computer is not limited to pure hardware, such as a CPU, but may include firmware, OS and peripheral devices, as a matter of course.

Furthermore, the present invention includes a program that carries out the operations of all or part of the steps (or processes, operations, actions, etc.) of the above-mentioned recording method of the present invention by using a computer and operates in cooperation with the computer.

Part of the means (or apparatuses, devices, circuits, portions, etc.) of the present invention and part of the steps (or processes, operations, actions, etc.) of the present invention designate several means or steps in the plural means or steps thereof or designate part of functions or part of actions in one means or step thereof.

In addition, part of the apparatuses (or devices, circuits, portions, etc.) of the present invention designates several apparatuses in the plural apparatuses or designates part of the means (or devices, circuits, portions, etc.) in one apparatus or designates part of the functions in one means.

Furthermore, a recording medium on which the program of the present invention has been recorded and which is readable by a computer is also included in the present invention. Still further, a utilization form of the program of the present invention may be an embodiment that is recorded on a recording medium readable by a computer and operates in cooperation with the computer. Still further, another utilization form of the program of the present invention may be an embodiment that is transmitted through a transmission medium, is read by a computer and operates in cooperation with the computer. Still further, the recording medium includes ROM and the like, and the transmission medium includes a transmission medium, such as the Internet, light, electric wave, sound wave, etc.

Still further, the configuration of the present invention may be attained by software or by hardware.

Still further, the present invention includes a medium having a program that carries out all or part of the functions of all or part of the means of the above-mentioned recording apparatus of the present invention by using a computer, the medium being readable by the computer and the above-mentioned program being used to carry out the above-mentioned functions in cooperation with the computer.

Still further, the present invention includes a medium having a program that carries out all or part of the operations of all or part of the steps of the above-mentioned recording method of the present invention by using a computer, the medium being readable by the computer and the above-mentioned program being used to carry out the above-mentioned operations in cooperation with the computer.

As described above, the invention is, for example, a recording/reproducing apparatus of recording/reproducing input image signals on a disk-shaped recording medium, comprising generation means of simultaneously generating a first recording bit stream capable of forming an image independently from the same input video signal and a second recording bit stream capable of forming an image independently at a bit rate not higher than that of the above-mentioned first recording bit stream, recording means of simultaneously recording the above-mentioned first and second recording bit streams on the above-mentioned disk-shaped recording medium, first input/output means of outputting at least the above-mentioned first recording bit stream, and second input/output means of outputting at least the above-mentioned second bit stream.

Still further, the invention is, for example, the above-mentioned recording/reproducing apparatus being characterized in that the above-mentioned second input/output means is an interface means to which a compact memory apparatus can be connected.

Still further, the invention is, for example, the above-mentioned recording/reproducing apparatus comprising a control table of controlling the above-mentioned bit streams recorded on the above-mentioned disk-shaped recording medium, display means of displaying the contents of the above-mentioned control table on a display device, and selection means of selecting the displayed contents, being characterized in that the above-mentioned second bit stream is copied or moved between the above-mentioned disk-shaped recording medium and the above-mentioned second input/output means or between the above-mentioned disk-shaped recording medium and the compact memory apparatus connected to the second input/output means by using the above-mentioned display means and the above-mentioned selection means.

Still further, the invention is, for example, the above-mentioned recording/reproducing apparatus comprising control means of controlling the elapsed reception time of the above-mentioned first record bit stream or the above-mentioned second record bit stream having been recorded on the above-mentioned disk-shaped recording medium, being characterized in that, when the above-mentioned bit stream is received as plural divided portions, reproduction is carried out automatically from the continuation of the portion received last.

Still further, the invention is, for example, the above-mentioned recording/reproducing apparatus being characterized in that, when the above-mentioned first record bit stream has been received halfway and when a second record bit stream generated from the same video signal as that of the above-mentioned first record bit stream is copied or moved or received between the above-mentioned disk-shaped recording medium and the above-mentioned second input/output means or between the above-mentioned disk-shaped recording medium and the compact memory apparatus connected to the second input/output means, the above-mentioned second record bit stream is processed automatically from the continuation of the received image.

Still further, the invention is, for example, the above-mentioned recording/reproducing apparatus being characterized in that, when the above-mentioned second record bit stream has been received halfway and when a first record bit stream generated from the same video signal as that of the above-mentioned second record bit stream is received, the above-mentioned first record bit stream is reproduced automatically from the continuation of the received image.

Still further, the invention is, for example, the above-mentioned recording/reproducing apparatus comprising image generation means of simultaneously reading the above-mentioned plural second record bit streams having been recorded on the above-mentioned disk-shaped recording medium and simultaneously generating plural images.

Still further, the invention is, for example, the above-mentioned recording/reproducing apparatus comprising image generation means of simultaneously reading the above-mentioned plural second record bit streams having been recorded on the above-mentioned disk-shaped recording medium and simultaneously generating plural images, means of reading the above-mentioned first record bit stream and generating an image, means of selecting one image from the above-mentioned plural images displayed simultaneously, and generation means of generating an image from the above-mentioned first bit stream generated by the same video signal as that of the second record bit stream selected by the above-mentioned selection means.

Still further, the invention is, for example, the above-mentioned recording/reproducing apparatus comprising display means of simultaneously reading the above-mentioned plural second record bit streams and the above-mentioned first record bit stream having been recorded on the above-mentioned disk-shaped recording medium, and simultaneously generating plural images from the above-mentioned plural second record bit streams and an image from the above-mentioned first record bit stream, and composing and displaying the image generated from the first record bit stream in a large size and the images generated from the second record bit streams in a small size.

Still further, the invention is, for example, the above-mentioned recording/reproducing apparatus comprising means of selecting one of the above-mentioned images composed and displayed in the small size, being characterized in that after the above-mentioned selection, the image generated from the selected second record bit stream is replaced with an image decompressed from the second record bit stream generated from the same input video signal as that of the image displayed in the large size, and that the image displayed in the large size is replaced with the image decompressed from the first record bit stream generated from the same input video signal as that of the above-mentioned selected second record bit stream and then displayed.

Still further, the invention is, for example, the above-mentioned recording/reproducing apparatus being characterized in that first or second record bit streams can be obtained from public circuits via a connection means connected to the above-mentioned input/output terminal.

Still further, the invention is, for example, the above-mentioned recording/reproducing apparatus being characterized in that the compact memory apparatus is a removable semiconductor memory apparatus.

Still further, the invention is, for example, the above-mentioned recording/reproducing apparatus being characterized in that the compact memory apparatus is a removable hard disk apparatus.

Still further, the invention is, for example, the above-mentioned recording/reproducing apparatus being characterized in that the removable semiconductor memory apparatus is a memory apparatus formed of a flash ROM.

Still further, the invention is, for example, the above-mentioned recording/reproducing apparatus being characterized in that the memory apparatus formed of a flash ROM is an SD memory apparatus.

Still further, the invention is, for example, the above-mentioned recording/reproducing apparatus being characterized in that the memory apparatus formed of a flash ROM is a compact flash memory apparatus.

Still further, the invention is, for example, the above-mentioned recording/reproducing apparatus being characterized in that the memory apparatus formed of a flash ROM is a memory stick apparatus.

Still further, the invention is, for example, the above-mentioned recording/reproducing apparatus being characterized in that the memory apparatus formed of a flash ROM is a PC card type memory apparatus.

Still further, the invention is, for example, the above-mentioned recording/reproducing apparatus being characterized in that the above-mentioned second record bit stream is generated by carrying out code length control so that the size thereof matches the recording capacity of the memory means.

Still further, the invention is, for example, the above-mentioned recording/reproducing apparatus being characterized in that the second input/output means is wireless input/output means.

Still further, the invention is, for example, a collection of information formed of a program that is used to carry out all or part of the functions of all or part of the means of the above-mentioned invention by using a computer.

Therefore, in accordance with the present invention, for example, carrying of recorded images by using a removable low-capacity recording medium, easy recording of images in a removable low-capacity recording medium by using screen display, easy setting of instructions regarding rates and times during compression by using screen display, outdoor reception of the continuation of images having been received at home or the opposite of this, easy understanding and selection of recorded contents by simultaneous reproduction of images, checking of recorded contents on small screens while watching a high-quality image on a large screen, reception of images from remote sites through public circuits, and downloading of high-quality images from remote sites, which were impossible conventionally, are made possible.

### INDUSTRIAL APPLICABILITY

As clarified by the above-mentioned descriptions, the present invention has advantages wherein recorded images and sound can be carried easily by using a low-capacity memory medium so as to be received in the open air, or can be received at remote sites via low-speed lines, such as telephone lines, for example.

## Claims

1. A recording apparatus comprising:
generation means of generating (1) a first bit stream and (2) a second bit stream having a bit rate less than the bit rate of said first bit stream by using a video signal input externally,
recording means of recording said generated first bit stream and said generated second bit stream on a predetermined medium,
first bit stream output means of outputting said recorded first bit stream, and
second bit stream output means, having an interface connectable to a predetermined compact memory apparatus, of outputting said recorded second bit stream.

2. A recording apparatus as set forth in claim 1, wherein the bit rate of said second bit stream is determined in consideration of the recording capacity of said compact memory means.

3. A recording apparatus as set forth in claim 1, comprising display means of carrying out display on the basis of the contents of a control table of controlling at least said recorded second bit streams, and selection means of selecting a predetermined second bit stream from said recorded second bit streams, wherein
said second bit stream output means outputs said selected second bit stream.

4. A recording apparatus as set forth in claim 1, comprising control means of controlling the received range, received by the user, of said recorded first bit stream and said recorded second bit stream.

5. A recording apparatus as set forth in claim 4, wherein
said recorded first bit stream is output from said first bit stream output means and used for reception by said user,
said control means controls the received range, received by said user, of said first bit stream, and
said second bit stream output means outputs the unreceived range, other than the received range of said controlled first bit stream, of the second bit stream generated by using the video signal used to generate the first bit stream.

6. A recording apparatus as set forth in claim 4, wherein
said recorded second bit stream is output from said second bit stream output means and used for reception by said user,
said control means controls the received range, received by said user, of said second bit stream, and
said first bit stream output means outputs the unreceived range, other than the received range of said controlled second bit stream, of the first bit stream generated by using the video signal used to generate the second bit stream.

7. A recording apparatus as set forth in claim 1, comprising image display means of displaying (1) an image using a first bit stream or (2) plural images using respective plural second bit streams, having been recorded on said medium, and selection means of selecting a predetermined second bit stream from said recorded second bit streams by utilizing the result of the display of plural images by using said respective plural second bit stream, wherein
said image display means displays an image using said first bit stream by using said first bit stream generated by utilizing the video signal utilized for the generation of the selected second bit stream.

8. A recording apparatus as set forth in claim 1, comprising image display means of displaying (1) an image using a first bit stream and (2) plural images using respective plural second bit streams, having been recorded on said medium, simultaneously.

9. A recording apparatus as set forth in claim 1, wherein said second bit stream output means has an interface of connecting to a predetermined communication network using wire and/or wireless.

10. A recording method comprising:
a step of generating (1) a first bit stream and (2) a second bit stream having a bit rate less than the bit rate of said first bit stream by using a video signal input externally,
a step of recording said generated first bit stream and said generated second bit stream on a predetermined medium,
a step of outputting said recorded first bit stream, and
a step of outputting said recorded second bit stream by utilizing an interface connectable to a predetermined compact memory apparatus.

11. A program causing a computer to execute all or part of: a step of generating (1) a first bit stream and (2) a second bit stream having a bit rate less than the bit rate of said first bit stream by using a video signal input externally, a step of recording said generated first bit stream and said generated second bit stream on a predetermined medium, a step of outputting said recorded first bit stream, and a step of outputting said recorded second bit stream by utilizing an interface connectable to a predetermined compact memory apparatus; in the recording method set forth in claim 10.

12. A medium having said program set forth in claim 11, being processable by a computer.
